Europäisches Patentamt

European Patent Office

Office européen des brevets

(11) Veröffentlichungsnummer: **0 253 244 B1**

(12) # EUROPÄISCHE PATENTSCHRIFT

(45) Veröffentlichungstag der Patentschrift: **17.04.91**

(51) Int. Cl.⁵: **G09F  13/22**, F21Q 1/00, H05K 1/02

(21) Anmeldenummer: **87109642.6**

(22) Anmeldetag: **04.07.87**

(54) **Verfahren zur Herstellung von Leuchtplatten mit lichtemittierenden Dioden (LED) und durch dieses Verfahren erhaltene Signalleuchte.**

(30) Priorität: **11.07.86 FR 8610148**

(43) Veröffentlichungstag der Anmeldung:
**20.01.88 Patentblatt  88/03**

(45) Bekanntmachung des Hinweises auf die
Patenterteilung:
**17.04.91 Patentblatt  91/16**

(84) Benannte Vertragsstaaten:
**DE ES FR GB IT**

(56) Entgegenhaltungen:
**WO-A-80/01860**
**DE-A- 3 132 594**
**DE-A- 3 438 154**
**DE-U- 1 769 868**
**US-A- 4 173 035**

**IBM TECHNICAL DISCLOSURE BULLETIN,
Band 25, Nr. 7B, Dezember 1982, Seite 3606,
New York, US; N.G. AAKALU et al.: "Integral
heatsink printed circuit card"**

(73) Patentinhaber: **VALEO VISION**
**17, rue Henri Gautier**
**F-93012 Bobigny Cédex(FR)**

(72) Erfinder: **Boucheron, Jean Louis**
**6, Hameau du Rougeau**
**F-77176 Savigny le Temple(FR)**

(74) Vertreter: **Cohausz & Florack Patentanwälte**
**Postfach 14 01 61 Schumannstrasse 97**
**W-4000 Düsseldorf 1(DE)**

**Beschreibung**

Die Erfindung bezieht sich auf ein Verfahren zur Herstellung einer Leuchtplatte mit lichtemittierenden Dioden.

Es ist vorgeschlagen worden, Signalleuchten für Kraftfahrzeuge unter Verwendung von LED als Lichtquellen an Stelle der üblichen Glühquellen herzustellen.

Der wesentliche Vorteil dieser neuen Lichtquellen liegt in ihren geringen Abmessungen, die es ermöglichen, eine Signalleuchte herzustellen, die im Vergleich zu den bekannten Signalleuchten sehr dünn ist, bei denen eine Glühlampe im Brennpunkt eines Reflektors angeordnet und das ganze durch eine eingefärbte transparente Scheibe abgeschlossen ist. Die Möglichkeit eines Einsatzes von Leuchtdioden in den bei Signalleuchten für Kraftfahrzeuge verwendeten Farben rot und orange, die in gelöschtem Zustand farblos sind, ermöglicht zudem, die Farbe der Leuchten den Farben des Kraftfahrzeugs im gelöschten Zustand, im Gegensatz zu den üblichen Signalleuchten, bei denen die Farben der transparenten Abschlußscheibe immer sichtbar sind.

Die Verwendung von LED als Lichtquellen für Signalleuchten an Kraftfahrzeugen trifft jedoch auf zahlreiche Schwierigkeiten, so daß es praktisch keine Signalleuchte dieser Art gibt, die industriel hergestellt wird.

Aus US-PS-4173035 sind zwar flexible Bänder bekannt, bei denen auf langen, kupferkaschierten Folienstreifen LED's in einer linearen Kette angebracht sind, die durch geätzte Leiterbahnen miteinander verbunden sind, doch eignen sich diese bekannten Bänder nicht zur Ausbildung von flächigen, formstabilen und räumlich sich erstreckenden Leuchtplatten, wie sie für eine Verwendung als Signalleuchte benötigt werden.

Es sind darüberhinaus Versuche mit Dioden durchgeführt worden, die in Form von Matrizen unmittelbar in einen Träger eingesetzt wurden. Die Wahl eines derartigen Trägers, der das Herstellverfahren für die Dioden aushalten und danach die mechanischen und thermischen Funktionen einer Signalleuchte erfüllen muß, stellt ein Problem dar, das bis heute praktisch nicht gelöst werden konnte. Darüber hinaus ist es mit diesem Verfahren nicht möglich, beliebige Signalleuchtenformen herzustellen.

Daher ist es Aufgabe der Erfindung, ein neuartiges Verfahren zu liefern, mit dem es möglich ist, flächige, formstabile und sich räumlich erstreckende LED-Platten von beliebiger Form herzustellen, die sich unmittelbar als Signalleuchte verwenden lassen.

Zu diesem Zweck ist das erfindungsgemäße Verfahren dadurch gekennzeichnet, daß die eingekapselten LED auf eine metallische Trägerplatte aus tiefziehbarem Werkstoff montiert werden, die über eine Klebschicht mit einer weichen Kunststofffolie abgedeckt ist, deren Oberfläche kupferkaschiert und zur Ausbildung zweckmäßiger elektrischer Stromkreise geätzt und verzinnt ist, wobei die LED in einem ersten Verfahren-sschritt automatisch im Auftragverfahren eingebaut und im Tauchlöt- oder Aufschmelzverfahren befestigt werden und die Trägerplatte daran anschließend zu Grundplatten geschnitten wird, die auf die erwünschte Form gezogen werden.

In einer bevorzugten Ausführungsform der Erfindung umfaßt die metallische Trägerplatte auf der der Kunststofflolie entgegengesetzten Seite Rillen, die dazu bestimmt sind, beim Prägen die Nullachse möglichst nahe an die Oberfläche der Folie zu bringen. Diese Rillen bieten den zusätzlichen Vorteil, daß sie die Abfuhr der durch die Dioden erzeugten Wärme begünstigen. Die Rillen können ein Rasternetz bilden, das eine Prägung in mehreren Richtungen ermöglicht.

In einer weiteren Ausführungsform kann man um die LED herum Reflektoren anordnen und/oder die Dioden in einen Klarsichtstoff hüllen, der in seiner Dicke optische Elemente wie Prismen, Ringlinsen etc. bildet, damit die Leuchtkraft einer jeden Diode über die Außenfläche des Klarsichtstoffes verteilt wird.

Im folgenden soll die Erfindung anhand von Ausführungsbeispielen näher erläutert werden.

Es zeigen:

Figur 1: eine schematische Schnittansicht eines Teils einer mit dem erfindungsgemäßen Verfahren hergestellten Leuchtplatte;

Figur 2: eine schematische Draufsicht der Platte in Figur 1;

Figur 3: eine Schnittansicht eines Teils eines Trägers nach einer Variante der Erfindung;

Figur 4: eine Ansicht des Trägers in Figur 3 von unten, und

Figur 5: eine schematische Schnittansicht einer Signalleuchte nach einem Ausführungsbeispiel der Erfindung.

Lichtemittierende in Mikrogehäusen verkapselte Dioden 1 sind auf einem Träger montiert. Der Träger besteht aus einem metallischen Teil 2 aus tiefziehfähigem Werkstoff wie Aluminium oder vergüteter Stahl, auf dem eine weiche Kunststofffolie 3 mit Hilfe eines Klebfilms 4 befestigt ist.

Die Folie 3 weist auf ihrer dem metallischen Teil 2 entgegengesetzten Fläche eine Kupferkaschierung 5 auf, die zuvor durch ein herkömmliches Verfahren zum Bilden erwünschter Anschlüsse geätzt und verzinnt worden ist. Die Dioden 1 werden durch einen Automaten zum Auflöten zugeführt und im Tauchlöt- oder Aufschmelzverfahren befestigt.

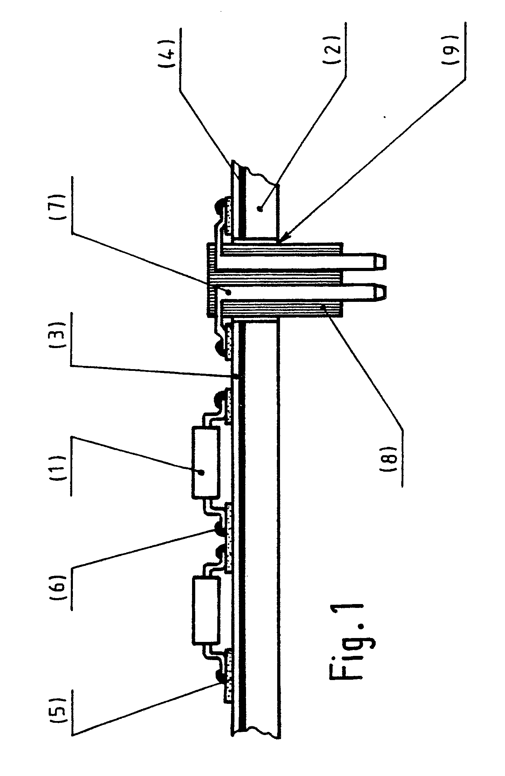

Andere elektrische oder elektronische Bauelemente wie Widerstände, Kondensatoren, Transistoren, integrierte Schaltungen etc. können auf den Träger 2, 3, 4, 5 gleichzeitig mit den Dioden 1 oder später montiert werden. Beispielsweise ist in Figur 1 ein Stecker mit zwei Stiften 7 dargestellt, die an den Stromkreis 5 mittels Tauchlöten angeschlossen sind, wobei diese Stifte 7 in einem Träger aus Kunststoff 8 ausgegossen sind, der durch ein im Träger eingearbeitetes Fenster 9 geht.

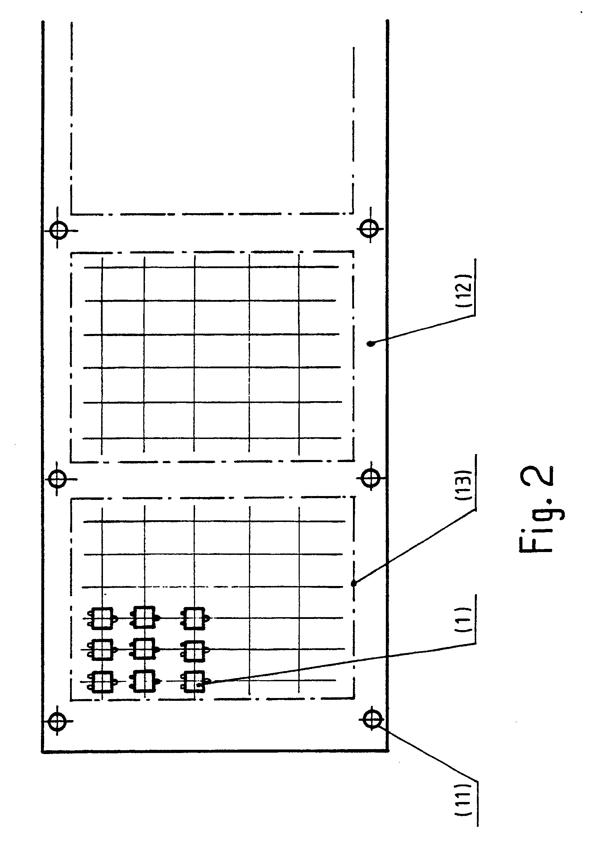

Figur 2 zeigt in einer Ansicht von oben (Bauelementenseite) eine nach dem zuvor beschriebenen Verfahren hergestellte Platte. Das Herstellverfahren ermöglicht eine Montage der Bauelemente durch automatisches Auflöten mit einer zweckmäßigen Maschine.

Die Bauteile 10 sind nicht alle dargestellt. Bei der Montage der Bauelemente wird die Positionierung der Schaltungen durch Positionierlöcher 11 sichergestellt. Nach Montage aller Mikrogehäuse und dann der Bauelemente 10, die von Hand montiert werden können, zum Beispiel spezifische Bauelemente wie Stecker, erfolgt das Löten beim Durchlauf der Platte in einer Tauchlötmaschine oder in einem Aufschmelzofen.

Anschließend kann, indem die Trägerplatte 12 durch dafür vorgesehene Zentrierlöcher 11 geführt wird, an einem geeigneten Werkzeug das Ausschneiden der Grundplatten erfolgen, deren Kontur durch die Punktierung 13 festgelegt ist. Dieser Schneidvorgang kann entlang einer geeigneten Kontur entsprechend der gewünschten Form stattfinden. Desgleichen kann der Schneidvorgang an einem Werkzeug ausgeführt werden, das gleichzeitig einen Ziehvorgang bewirkt und auf diese Weise den Erhalt eines Teils mit gewünschter Form und Kontur ermöglicht.

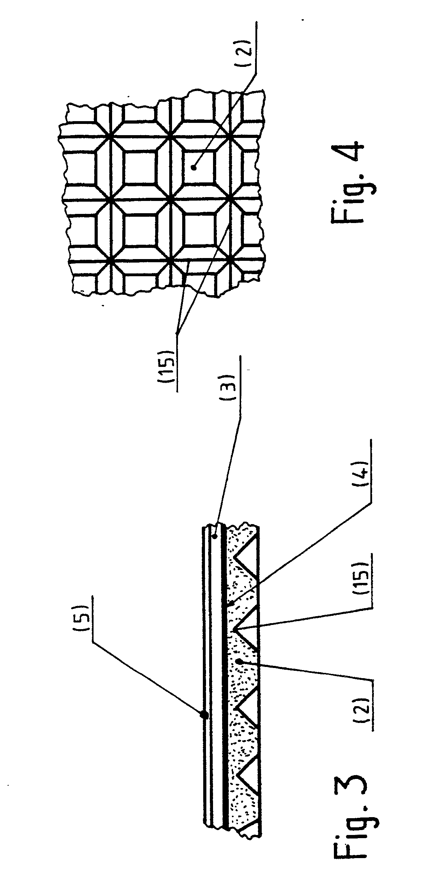

Die Figuren 3 und 4 zeigen eine Verbesserung des metallischen Teils 2 des mit Hilfe des elastischen Klebfilms 4 mit der die Kupferkaschierung tragenden weichen Folie 3 verbundenen Trägers.

Diese Verbesserung besteht in der Montage der Bauelemente und deren Befestigung, wobei die Trägerplatte 2 im Hinblick auf ihre Ätzung einwandfrei eben gehalten wird, um einen Ziehvorgang zu ermöglichen, der die Bauelemente im Zeitpunkt des Ausschneidens und des Ziehens der Platte möglichst geringen Spannungen unterwirft.

Diese Verbesserung wird erzielt, indem in die Platte 2 Rillen 15 so eingearbeitet werden, daß die Nullachse beim Prägen möglichst nahe an die die Bauelemente tragende Fläche kommt.

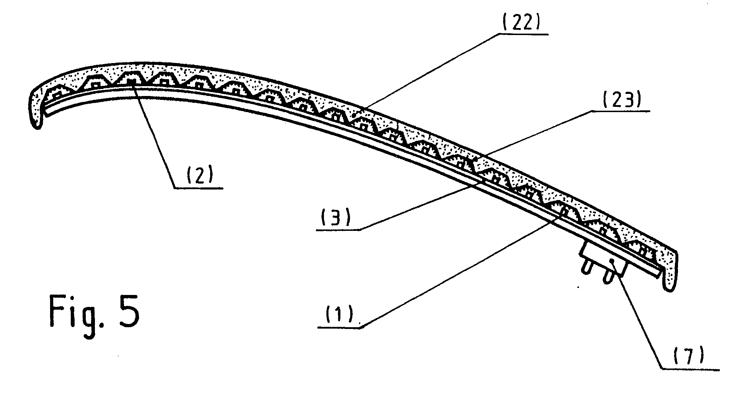

Figur 5 zeigt schematisch eine Ausführung, bei der ein Ziehvorgang verwendet wird, in den die lichtemittierenden Dioden 1 im Mikrogehäuse, die weiche Folie 3, der metallische Träger 2, der Anschlußstecker 7 und ein Umhüllungstransparent 22 einbezogen werden, das eingefärbt sein kann, aber nicht sein muß, und in seiner Dicke einen optischen Teil 23umfaßt, der Prismen, Ringlinsen oder ähnliches zum Verteilen der durch die verschiedenen Dioden übertragenen Beleuchtung auf die Außenoberfläche des Transparents 22 bildet. Es kann auch vorgesehen werden, jede Diode 1 mit einem Reflektor (nicht dargestellt) zu umgeben.

Die Erfindung ermöglicht den unmittelbaren Erhalt einer der Form des Fahrzeugs angepaßten Signalleuchte, die dort leicht befestigt und angeschlossen werden kann. Die Leuchte ist wasserdicht und äußerst dünn und umfaßt trotzdem Mittel zur Wärmeableitung. Die elektronischen Bauelemente, insbesondere die lichtemittierenden Dioden 1, können vorzugsweise automatisch ausgewählt werden, damit sie identische und widerholbare Eigenschaften haben.

## Ansprüche

1.  Verfahren zur Herstellung einer Leuchtplatte mit lichtemittierenden Dioden, LED, **dadurch gekennzeichnet,** daß eingekapselte LED (1) auf eine metallische Trägerplatte (2) aus tiefziehfähigem Werkstoff montiert werden, die mittels einer Klebschicht (4) mit einer weichen Kunststoffolie (3) verbunden ist, deren Oberfläche (4) mit Kupfer kaschiert und zur Ausbildung geeigneter elektrischer Stromkreise geätzt und verzinnt ist, wobei in einem ersten Schritt die LED (1) automatisch im Tauchlöt- oder Aufschmelzverfahren montiert werden und anschließend die Trägerplatte (2) in Grundplatten zerschnitten wird, die auf die gewünschte Form gezogen werden.

2.  Verfahren nach Anspruch 1, **dadurch gekennzeichnet,** daß die metallische Trägerplatte (2) auf ihrer der Kunststoffolie (3) entgegengesetzten Fläche Rillen (15) umfaßt, die dazu bestimmt sind, beim Prägen die Nullachse möglichst nahe an die Fläche neben der Folie (3) zu bringen.

3.  Verfahren nach Anspruch 2, **dadurch gekennzeichnet,** daß die Rillen (15) ein Rasternetz bilden.

4.  Verfahren nach einem der vorhergehenden Ansprüche, **dadurch gekennzeichnet,** daß um die lichtemittierenden Dioden (1) Refelektoren angeordnet werden.

5.  Verfahren nach einem der vorhergehenden Ansprüche, **dadurch gekennzeichnet, daß die** Dioden (1) in einen Klarsichtstoff (24) gehüllt werden, der in seiner Dicke optische Elemente (23) wie Prismen, Ringlinsen etc. zum Verteilen der Leuchtkraft der einzelnen Dioden auf der Außenfläche dieses Klarsichtsoffs (22) bildet.

## Claims

1. A process for producing a lamp panel comprising light emitting diodes, LED, characterized in that encapsulated LED (1) are mounted on a metallic carrier plate (2) made of material which can be deep drawn and is attached by means of an adhesive layer (4) to a soft plastic sheet (3), the surface (4) of which is coated with copper and etched and tinned in order to form suitable electrical circuits, wherein in a first stage the LED (1) are automatically mounted in a dip-soldering or fusing process and then the carrier plate (2) is cut into base plates which are drawn into the desired shape.

2. A process according to claim 1, characterized in that the metallic carrier plate (2) comprises grooves (15) in it side facing away from the plastic sheet (3) which are so defined that, on stamping, the neutral axis is brought as close as possible to the surface against the sheet (3)

3. A process according to claim 2, characterized in that the grooves (15) form a grid layout.

4. A process according to any one of the preceding claims, characterized in that reflectors are arranged around the light emitting diodes (1).

5. A process according to any one of the preceding claims, characterized in that the diodes (1) are encased in a transparent substance (24) which forms optical elements (23), such as prisms, circular lenses etc. in its thickness, for distributing the illuminating power of the individual diodes on the outer surface of this transparent substance (22).

## Revendications

1. Procédé de fabriction d'une plaque éclairante à diodes électroluminescentes, caractérise par le fait que des diodes électroluminescentes encapsulées (1) sont montées sur une plaque-support métallique (2) en matériau emboutissable qui est liée par l'intermédiaire d'une couche adhésive (4) à un film synthétique souple (3) dont la face supérieure (4) est cuivrée, gravée pour former les circuits électriques convenables, et étamée, dans lequel, dans une première étape, les diodes électroluminescentes (1) sont montées automatiquement par soudage à la vague ou par fusion, et ensuite la plaque-support (2) est découpée en plaques élémentaires qui sont embouties à la forme désirée.

2. Procédé selon la revendication 1, caractérisé par le fait que la plaque-support métallique (2) comporte, sur sa face opposée audit film synthétique (3), des rainures (15) destinées à reporter la fibre neutre, lors du cambrage, le plus près possible de la surface adjacente audit film (3).

3. Procédé selon la revendication 2, caractérisé par le fait que les rainures (15) forment un quadrillage.

4. Procédé selon l'une des revendications 1 à 3, caractérisé par le fait que des réflecteurs sont disposés autour des diodes électroluminescentes (1).

5. Procédé selon l'une des revendications 1 à 4, caractérisé par le fait qu'on enrobe les diodes (1) dans une matière transparente (24) qui forme dans son épaisseur des éléments optiques (23) tels que prismes, échelons de Fresnel, etc., pour produire une répartition de l'éclairement de chacune des diodes sur la surface externe de ladite matière transparente (22).

Fig.1

EP 0 253 244 B1

(12)

(13)

(1)

(11)

Fig. 2

(5)

(3)

(2)    (15)    (4)

Fig. 3

(15)

(2)

Fig. 4

EP 0 253 244 B1

Fig. 5